(19) Europäisches Patentamt

European Patent Office

Office européen des brevets

(11) **EP 0 916 959 B1**

(12) **EUROPÄISCHE PATENTSCHRIFT**

(45) Veröffentlichungstag und Bekanntmachung des Hinweises auf die Patenterteilung:
**01.06.2005 Patentblatt 2005/22**

(51) Int Cl.⁷: **G01R 31/36**

(21) Anmeldenummer: **98119117.4**

(22) Anmeldetag: **09.10.1998**

(54) **Verfahren zur Bestimmung der Startfähigkeit der Starterbatterie eines Kraftfahrzeugs**

Method for determining the starting ability of the starter-battery of a motor-vehicle

Procédé de détermination de la capacité à démarrer de la batterie de démarrage d'un véhicule automobile

(84) Benannte Vertragsstaaten:
**DE ES FR GB IT SE**

(30) Priorität: **13.11.1997 DE 19750309**

(43) Veröffentlichungstag der Anmeldung:
**19.05.1999 Patentblatt 1999/20**

(73) Patentinhaber: **VB Autobatterie GmbH**
**30419 Hannover (DE)**

(72) Erfinder: **Richter, Gerolf Dr.**
**31139 Hildesheim (DE)**

(74) Vertreter: **Lins, Edgar, Dipl.-Phys. Dr.jur. et al**
**Gramm, Lins & Partner GbR,**
**Theodor-Heuss-Strasse 1**
**38122 Braunschweig (DE)**

(56) Entgegenhaltungen:
WO-A-90/04188          DE-A- 3 901 680
FR-A- 2 358 029          FR-A- 2 561 391
US-A- 4 731 601

**Beschreibung**

Die Erfindung betrifft ein Verfahren zur Bestimmung der Startfähigkeit der Starterbatterie eines Kraftfahrzeugs.

Für die Fähigkeit einer Starterbatterie, ein Kraftfahrzeug mit einem Verbrennungsmotors zu starten, sind der Ladezustand und der Fortschritt der Alterung bzw. der sich abzeichnende Kapazitätsverfall maßgeblich, da dadurch die der Starterbatterie entnehmbare Stromstärke bzw. deren Leistungsabgabe begrenzt wird.

Bei einem modernen Kraftfahrzeug sind die Eigenschaften von Generator, Batterie und der elektrischen Verbraucher technisch so aufeinander abgestimmt, daß es fast nur noch im Falle einer massiven Fehlbedienung zu so niedrigen Batterieladezuständen kommen kann, daß die Startfähigkeit oder andere Funktionen nicht mehr gewährleistet sind. Damit ist die Frage nach einer zuverlässigen Anzeige für den Austausch der Batterie von großem Interesse. Insbesondere wenn sicherheitsrelevante elektrische Verbraucher, wie zum Beispiel elektrische Bremsen oder elektrisch unterstützte Lenkhilfen installiert sind, ist die Kenntnis über das voraussichtliche Nutzungsende der Batterie sehr wichtig.

Aus dem Dokument DE-C 3901680 ist ein Verfahren zur Überwachung der Kaltstartfähigkeit der Starterbatterie eines Verbrennungsmotors bekannt, bei dem der zeitliche Verlauf des beim Anlassen eintretenden Spannungsabfalls beobachtet und ausgewertet wird. Die Auswertung erfolgt dabei anhand von Grenzwerten einer aus Erfahrungswerten gewonnenen Kennlinie und in Abhängigkeit von der Batterietemperatur.

Weiterhin ist aus dem Dokument DE-A 2730258 eine Vorrichtung zum Anzeigen des Ladezustandes einer Fahrzeugbatterie bekannt, die neben der Batteriespannung und wenigstens eines weiteren Batterieparameters die Motortemperatur erfaßt und eine Warnanzeige liefert, wenn ein vorgegebener Grenzwert unterschritten wird.

Dokument DE-C 3712629 offenbart eine Meßvorrichtung für die verbleibende Lebensdauer einer Kraftfahrzeugbatterie, die die Batteriespannung und den dazugehörigen Laststromwert vor und nach dem erstmaligen Starten bei vollgeladenem Zustand der Batterie erfaßt, den temperaturkompensierten Innenwiderstand ermittelt und in einem Speicher ablegt sowie mit den bei den späteren Startvorgängen der Verbrennungskraftmaschine ermittelten Innenwiderstandswerten vergleicht. Die Anzeige erfolgt danach in Abhängigkeit von vorgegebenen, abgespeicherten Schwellwerten.

In der WO 90/04188 ist eine Schaltungsanordnung zur Überwachung einer Kraftfahrzeug-Starterbatterie beschrieben, mit der die Batteriekapazität, der Ladezustand und weitere Fehlerbedingungen durch Messung des Batteriestroms und der Batteriespannung an den Batterieklemmen ermittelt wird. Der Innenwiderstand der Batterie für andere als die vorliegende Temperatur wird mit Hilfe von Daten ermittelt, die entweder von dem Batteriehersteller geliefert oder während einer ersten Nutzungsphase der neuwertigen Starterbatterie bestimmt worden sind.

In der FR 2 358 029 A1 ist ein Zustandsindikator einer Kraftfahrzeugbatterie beschrieben, bei dem die Motortemperatur und ein zum Innenwiderstand der Batterie lineares Signal ermittelt und ausgewertet wird.

Aus der FR 2 561 391 A1 ist ein Testgerät zur Überprüfung des Zustands eines Akkumulators bekannt, bei dem die Belastungsspannung nach einer Belastungsphase von etwa 1 bis 2 Sekunden ausgewertet wird.

In der nächstliegenden DE 39 01 680 A1 ist ein Verfahren zur Überwachung der Kaltstartfähigkeit einer Starterbatterie beschrieben, bei dem der zeitliche Verlauf des Spannungsabfalls an den Anschlussklemmen des Generators und damit auch der Starterbatterie beobachtet und ausgewertet wird. Der berücksichtigte Spannungsabfall ist dabei der über mindestens einem Verbraucher oder einer elektrischen Quelle anliegende Spannungsanteil. Bei der Beobachtung und Auswertung des zeitlichen Verlaufs des Spannungsabfalls an den Anschlussklemmen ist eine fortlaufende Grenzwertüberprüfung für jede Spannungsdifferenz erforderlich. Die Spannungseinbruchswerte werden mit Spannungswerten eines Kennlinienfeldes gemessen, dass von der Batterietemperatur abhängt und an den Alterungsprozess der Starterbatterie angepasst werden kann.

Aufgabe der Erfindung ist es, ein Verfahren anzugeben, welches die konkreten Eigenschaften der eingesetzten Starterbatterie besser erfasst und damit eine genauere Aussage über den Nutzungsendpunkt gestattet.

Erfindungsgemäß wird die Aufgabe durch ein Verfahren gelöst, wie es im Anspruch 1 angegeben ist.

Weiterhin vorteilhafte Ausgestaltungen des Verfahrens sind in den Ansprüchen 2 bis 5 dargelegt.

Im Unterschied zu denn herkömmlichen Verfahren wird der Spannungseinbruch, d. h. die Differenz der Batterieklemmenspannung unmittelbar vor dem Startvorgang und der ersten beim Startvorgang auftretenden relativen Batterieklemmen-Minimalspannung gemessen und die Spannungseinbruchswerte für mehrere Startvorgang gemittelt und ausgewertet. Es hat sich herausgestellt, dass hierdurch die Batteriealterungseffekte mit einfachen Mitteln gut erfasst werden können, sofern auch die Batterietemperatur und Motortemperatur berücksichtigt wird.

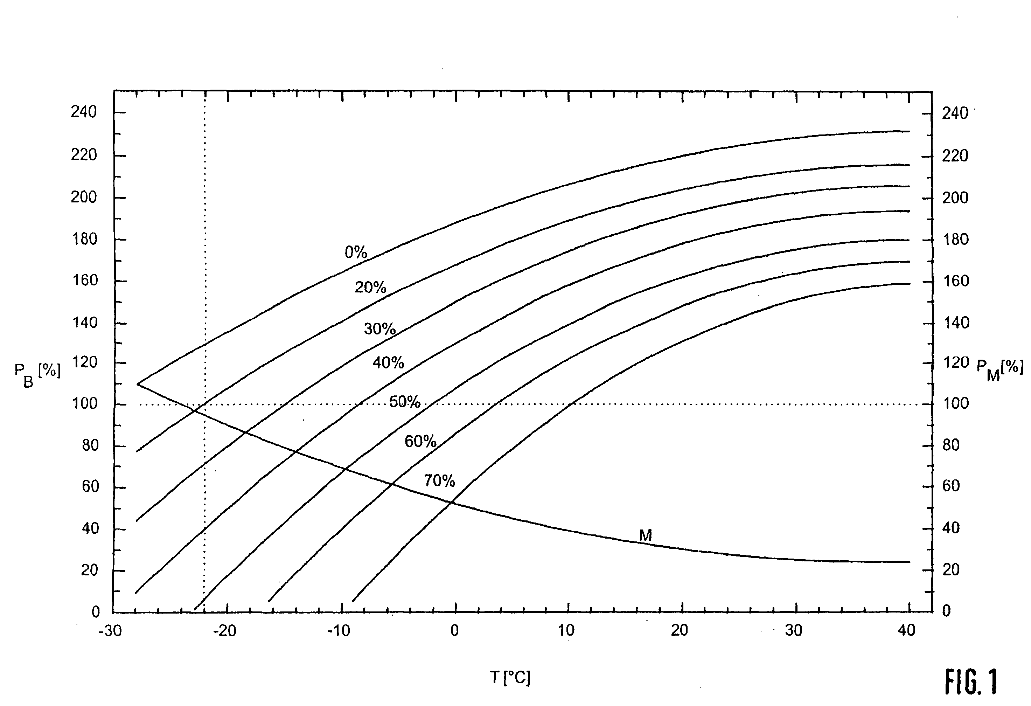

Die erfindungsgemäße Lösung ist im folgenden anhand der Figuren näher erläutert. Sie sieht ein direktes Verfahren zur Beurteilung der Fähigkeit der wohl wichtigsten Funktion einer Fahrzeugbatterie - der Startfähigkeit des Verbrennungsmotors - vor. Das Verfahren adaptiert sich an das Fahrzeug mit seiner jeweiligen Motorisierung und der zum Einsatz kommenden Batterie selbst, so dass die Angabe von Daten und Kennlinien überflüssig ist. Gemessen wird bei jedem Anlassen des Verbrennungsmotors der Spannungseinbruch an den Batterieklemmen $\Delta U_B$ sowie die Motorkühlmittel und die Batterie-Elektrolyttemperatur ($T_M$ bzw. $T_B$). Bekanntlich ist die Leistung zum Starten eines Verbrennungsmotors stark von der Kühlmittel- bzw. Öltemperatur abhängig. Mit sinkender Motortemperatur $T_M$ nimmt die erforderliche Startleistung $P_M$ aus Gründen der sich verstärkenden Haft- bzw. Gleitreibung überproportional zu. Dieses Verhalten des Motors ist in Figur 1 in der Kurve M dargestellt. Die Startleistung muss ausschließlich von der Batterie des Fahrzeuges erbracht werden, deren Leistungsvermögen mit fallender Temperatur überproportional abnimmt. Auch dies ist aus Figur 1 ersichtlich, in der die mit 0%, 20%, 30%, 40%, 50%, 60% und 70% bezeichneten Entladekurven die Leistungsabgabe der Batterie in Abhängigkeit vom Ladezustand (100%, 80%, 70%, 60%, 50%, 40% und 30%) und der Batterietemperatur darstellen. Der Widerstand $R_I$ beim Starten des Verbrennungsmotors, der die Summe aller Hemmnisse zur Bereitstellung des erforderlichen Startstromes ist, steht zu der Leistung, die für das Starten des Verbrennungsmotors benötigt wird, in folgender Beziehung:

$$P(T_M) = \Delta U_B^2 / R_I(T_B).$$

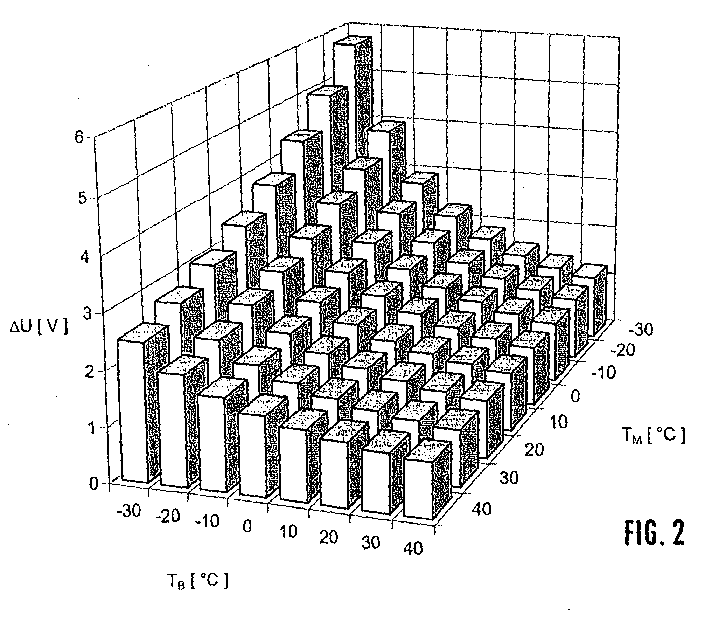

Daraus ergibt sich für den zu erwartenden Spannungseinbruch beim Starten des Verbrennungsmotors $\Delta U_B = \sqrt{P(T_M) \bullet R_I(T_B)}$. Da die erforderliche Startleistung $P(T_M)$ bei der jeweiligen Temperatur ($T_M$) für einen Motor mit seinen Nebenaggregaten in etwa konstant ist, und die Größe des Widerstandes $R_I$ bei der jeweiligen Temperatur $T_B$ sich in Abhängigkeit vom Verschleiß und Ladezustand der Batterie ändert, ist die Abweichung E von $\Delta U_B$ (t) nach der Gebrauchsdauer (t) im Vergleich zum Spannungseinbruch bei einer neuen Batterie ($\Delta U_B(t = 0)$ ein Maß für die Startleistung bzw. die Alterung der Batterie E (t) =$\Delta U_B$ (t) - $\Delta U_B$ (t=0). Bei jedem Start in der Batterieneuphase werden die Spannungseinbrüche der Klemmenspannung ($\Delta U_B$), die jeweilige Motortemperatur ($T_M$) und Batterietemperatur ($T_B$) in einem Speicher in einem dreidimensionalen Kennlinienfeld gemäß Figur 2 abgelegt. Die ermittelten Werte können mittels eines Regressionsverfahrens geglättet sowie durch Inter- und Extrapolation erweitert werden. Nach Abschluß der Neuphase wird bei jedem weiteren Start abgefragt, ob der Spannungseinbruch $\Delta U_B$ ($T_M$, $T_B$) größer als der im Speicher abgelegte Wert ist, der bei den gleichen Temperaturen $T_M$ und $T_B$ ermittelt wurde. Überschreitet die Differenz eine definierte Grenze E, so wird dies in eine Anzeige oder gegebenenfalls in einen Alarm umgesetzt. Bekanntermaßen ist der Innenwiderstand einer Batterie nicht nur temperaturabhängig sondern auch vom Ladezustand der Batterie abhängig. Eine hohe Differenz des Spannungseinbruchs ($E > E_{max}$) kann also nicht nur auf eine stark fortgeschrittene Alterung zurückgeführt werden, sondern auch auf einen unzureichenden Ladestatus. Beide Batteriezustände sind jedoch gleichermaßen unerwünscht. Zur Unterscheidung zwischen den genannten Ursachen wird, neben dem Spannungseinbruch beim Anlassen des Verbrennungsmotors unmittelbar vor dem Startvorgang auch die Ruhespannung gemessen. Bewegt sich die Ruhespannung, die eine geringe Temperaturabhängigkeit besitzt, über einem bestimmten Niveau $U_{omin}$, so ist eine Mangelladung nicht zu erwarten. Durch die Kontrolle der Ruhespannung ist die Anzeige des $E_{max}$-Wertes eine zuverlässige Angabe der Nutzungsdauer der Fahrzeugbatterie.

Ein besonderer Vorteil des erfindungsgemäßen Verfahrens besteht darin, daß sich das Verfahren an das Ausrüstungsniveau des jeweiligen Fahrzeugs selbständig anpaßt. So werden durch die erfaßten und abgespeicherten Meßwerte Unterschiede der jeweiligen Fahrzeuge hinsichtlich ihrer Ausstattung mit z.B. Automatikgetriebe, Diesel- oder Benzinmotor mit unterschiedlichen Zylinderanzahlen, Klimaanlage oder anderen bedeutenden Stromverbrauchern bei der Anzeige des Gebrauchsendes der Starterbatterie berücksichtigt.

**Patentansprüche**

1. Verfahren zur Bestimmung der Startfähigkeit der Starterbatterie eines Kraftfahrzeugs, **dadurch gekennzeichnet, dass** der an den Batterieklemmen der Starterbatterie gemessene Spannungseinbruch ($\Delta U_B$) als Differenz der Batterieklemmenspannung unmittelbar vor dem Startvorgang und der ersten beim Startvorgang auftretenden relativen Batterieklemmen-Minimal-Spannung beim Starten des Fahrzeugs gemessen und mit den Spannungswerten eines Kennlinienfeldes, welches über eine definierte Neuphase aus dem Mittelwert der beim Startvorgang gemessenen Spannungseinbrüchen ($\Delta U_B$) und zugehörigen Batterie- ($T_M$) sowie Motortemperaturen ($T_B$) besteht, verglichen wird und dass die Abweichung des aktuell ermittelten Spannungseinbruchs ($\Delta U_B$) von dem im Kennlinienfeld abgelegten Spannungseinbruch ermittelt wird und dass eine Anzeige oder Alarmfunktion ausgelöst wird, sobald die Abweichung einen vorgegebenen Wert überschreitet.

2. Verfahren nach Anspruch 1, **dadurch gekennzeichnet, dass** die Mittelwerte der Spannungseinbrüche ($\Delta U_B$) und die zugehörigen Motortemperaturen ($T_M$) und Batterietemperaturen ($T_B$) in einem Speicher über eine definierte Neuphase von 6 bis 18 Monaten abgelegt werden.

3. Verfahren nach Anspruch 1 oder 2, **dadurch ge-**

**kennzeichnet, dass** die gespeicherten Werte für den Vergleich mit den aktuell ermittelten Werten geglättet oder durch Interpolation oder Extrapolationsverfahren ergänzt werden.

4. Verfahren nach einem der Ansprüche 2 bis 3, **dadurch gekennzeichnet**, neben dem Spannungseinbruch die Ruhespannung vor dem Startvorgang gemessen und mit der Ruhespannung in der Neuphase verglichen wird.

5. Verfahren nach einem der Ansprüche 1 bis 4, **dadurch gekennzeichnet, dass** die Anzeige der Differenz des Spannungseinbruchs zu den abgespeicherten Werten in Form einer Tankuhr erfolgt, bei der die entsprechenden zulässigen Werte markiert sind.

**Claims**

1. Method for determining the starting ability of the starter battery of a motor vehicle, **characterized in that** the voltage drop ($\Delta U_B$), which is measured across the battery terminals of the starter battery, is measured as the difference between the battery terminal voltage immediately before the starting process and the first relative battery terminal minimum voltage occurring during the starting process when the vehicle is started and is compared with the voltage values of a family of characteristics, which, over a defined new phase, comprises the mean value of the voltage drops ($\Delta U_B$), measured during the starting process, and associated battery temperatures ($T_M$) and engine temperatures ($T_B$), and **in that** the discrepancy between the actually determined voltage drop ($\Delta U_B$) and the voltage drop stored in the family of characteristics is determined, and **in that** a display or alarm function is triggered as soon as the discrepancy exceeds a predetermined value.

2. Method according to Claim 1, **characterized in that** the mean values of the voltage drops ($\Delta U_B$) and the associated engine temperatures ($T_M$) and battery temperatures ($T_B$) are stored in a memory for a defined new phase of 6 to 18 months.

3. Method according to Claim 1 or 2, **characterized in that** the stored values are smoothed for the comparison with the actually determined values, or are supplemented by interpolation or extrapolation methods.

4. Method according to one of Claims 2 to 3, **characterized in that**, in addition to the voltage drop, the rest voltage is measured before the starting process and is compared with the rest voltage in the new phase.

5. Method according to one of Claims 1 to 4, **characterized in that** the difference between the voltage drop and the stored values is displayed in the form of a fuel gauge, on which the corresponding, permissible values are marked.

**Revendications**

1. Procédé pour déterminer la capacité à démarrer de la batterie de démarrage d'un véhicule automobile, **caractérisé en ce que** la baisse de tension ($\Delta U_B$) est mesurée sur les bornes de la batterie de démarrage comme différence entre la tension aux bornes de la batterie immédiatement avant le processus de démarrage et la première tension minimale relative, au niveau des bornes de la batterie produite au de démarrage du véhicule, et comparée aux valeurs de tension d'un champ de caractéristiques, qui comprend la valeur moyenne des baisses de tension ($\Delta U_B$) mesurées lors du processus de démarrage pendant une phase nouvelle définie ainsi que les températures ($T_B$) de la batterie et ($T_M$) du moteur associées, et on détermine l'écart de la baisse de tension ($\Delta U_B$) actuellement mesurée par rapport à la baisse de tension enregistrée dans le champ de caractéristiques, et une fonction de signalisation ou d'alarme est déclenchée dès que l'écart dépasse une valeur prédéfinie.

2. Procédé selon la revendication 1, **caractérisé en ce que** les valeurs moyennes des baisses de tension ($\Delta U_B$) ainsi que les températures ($T_M$) du moteur et les températures ($T_B$) de la batterie associées sont enregistrées dans une mémoire pendant une phase nouvelle définie de 6 à 18 mois.

3. Procédé selon la revendication 1 ou 2, **caractérisé en ce que** pour la comparaison avec les valeurs actuellement déterminées les valeurs enregistrées sont lissées ou complétées par interpolation ou par des procédés d'extrapolation.

4. Procédé selon l'une quelconque des revendications 2 à 3, **caractérisé en ce qu'** outre la baisse de tension, la tension de repos avant le processus de démarrage est mesurée et comparée avec la tension de repos dans la phase nouvelle.

5. Procédé selon l'une quelconque des revendications 1 à 4, **caractérisé en ce que** la signalisation de la différence entre la baisse de tension et les valeurs enregistrées s'effectue sous la forme d'une jauge de réservoir sur laquelle les valeurs admissibles correspondantes sont marquées.

FIG. 1

FIG. 2

EP 0 916 959 B1